# EUROPÄISCHE PATENTANMELDUNG

(11) **EP 4 495 300 A1**
(43) Veröffentlichungstag der Anmeldung: **22.01.2025**
(21) Anmeldenummer: 23186143.6
(22) Anmeldetag: 18.07.2023
(51) Int. Cl.: C30B 29/06, C30B 11/00, C30B 15/00, C30B 35/00, G01B 11/14

(54) **VERFAHREN UND ANLAGE ZUM ERMITTELN EINER EINRICHTHÖHE AN EINER TIEGELEINHEIT**

(71) Anmelder: Siltronic AG, 81677 München (DE)
(72) Erfinder: Moos, Patrick, 84568 Pleiskirchen (DE); Buschhardt, Thomas, 84489 Burghausen (DE)
(74) Vertreter: Hasenhütl, Eva

(57) **Zusammenfassung**

Die Erfindung betrifft ein Verfahren zur Ermittlung einer Einrichthöhe an einer, insbesondere wenigstens teilweise mit Bruchstücken, insbesondere Polysiliziumbruchstücken, befüllten Tiegeleinheit (2), mittels einer Anlage (1), wobei die Anlage (1) eine Messeinheit (1.1) umfasst, wobei das Verfahren wenigstens folgende Schritte umfasst: Erfassen von wenigstens einer geometrischen Abmessung der Tiegeleinheit (2), insbesondere umfassend das Erfassen einer Oberkantenkontur der Tiegeleinheit (2), insbesondere mittels der Anlage (1); Optisches und/oder taktiles Vermessen, insbesondere mittels der Anlage (1), einer Bezugsebene an der Tiegeleinheit (2); Optisches Vermessen, insbesondere mittels der Anlage (1), wenigstens eines Teils einer, vorzugsweise eines überwiegenden Teils einer, weiter vorzugsweise im Wesentlichen einer gesamten, Bruchtopografie, welche sich in der Tiegeleinheit (2) durch eine, insbesondere vorangegangene, wenigstens teilweise Befüllung mit Bruchstücken, insbesondere mit Polysiliziumbruchstücken, an der freien Oberfläche der Bruchstücke ausbildet; Ermitteln, insbesondere mittels der Anlage (1), wenigstens eines für die Einrichthöhe repräsentativen Wertes wenigstens auf Basis der Ergebnisse der optischen Vermessung des wenigstens einen Teils der, vorzugsweise eines überwiegenden Teils der, weiter vorzugsweise im Wesentlichen der gesamten, Bruchtopografie, und in Bezug auf die Ergebnisse der optischen und/oder taktilen Vermessung der Bezugsebene.

## Beschreibung

### Technisches Gebiet

Die Erfindung betrifft ein Verfahren zur Ermittlung einer Einrichthöhe an einer, insbesondere wenigstens teilweise mit Bruchstücken, insbesondere Polysiliziumbruchstücken, befüllten Tiegeleinheit. Die Erfindung betrifft weiterhin ein Verfahren zur Herstellung eines Einkristallstabs, umfassend das Verfahren zur Ermittlung der Einrichthöhe an der, insbesondere wenigstens teilweise mit Bruchstücken, insbesondere Polysiliziumbruchstücken, befüllten Tiegeleinheit. Die Erfindung betrifft weiterhin ein Verfahren zur Herstellung von Scheiben aus Halbleitermaterial, umfassend das Verfahren zur Ermittlung der Einrichthöhe an der, insbesondere wenigstens teilweise mit Bruchstücken, insbesondere Polysiliziumbruchstücken, befüllten Tiegeleinheit. Die Erfindung betrifft weiterhin eine Anlage, welche zur Ermittlung der Einrichthöhe ausgebildet ist.

### Stand der Technik und technische Aufgabe

Vor Beginn des eigentlichen Tiegelzieh-Prozesses gemäß CZ-Methode wird üblicherweise eine entsprechende Tiegeleinheit, üblicherweise in Form eines Quarz-Tiegels, manuell mit Polysiliziumbruchstücken befüllt. Diese Polysiliziumbruchstücke bestehen aus sogenanntem Poly-Bruch, also aus Bruchstücken in verschiedenen Größen. Die Befüllung der Tiegeleinheit erfolgt hierbei schichtweise und üblicherweise gemäß einer vorgebbaren Befüllungspezifikation.

Nun ist es üblich, dass im Zuge des sog. Einrichtvorgangs der Tiegeleinheit nach der Beendigung der manuellen Befüllung durch den Bediener, der Bediener mit einem konventionellen Lineal den Abstand an einer Stelle oder an mehreren Stellen an der freien Polybruch-Oberfläche zur Tiegeloberkante misst. Aus dem wenigstens einen abgelesen Abstandswert wird dann ein Wert für die Einrichthöhe abgeleitet (bei einer einzigen Messung entspricht der Abstand üblicherweise der sog. Einrichthöhe; bei Messung an mehreren Stellen wird die Einrichthöhe beispielsweise aus dem arithmetischen Mittel der an den mehreren Stellen abgelesenen Abstände ermittelt bzw. von diesen abgeleitet).

Ein gewisser Mindestabstand der Tiegelkante zur Polybruch-Oberfläche ist wichtig, da es ansonsten u.a. beim Zusammenfahren der Tiegeleinheit mit dem Vakuum-Hebeflansch und weiteren Komponenten der CZ-Ziehanlage zu einem Kontakt zwischen Graphitteilen und den Bruchstücken kommt und/oder beim Aufschmelzen der Bruchstücke sich Kohlenstoff in der Schmelze anreichert.

Dieses Ableseverfahren bzw. Ermittlungsverfahren der Einrichthöhe mittels eines Lineals und mit Augenmaß hat den Vorteil, sehr zügig und kostengünstig Werte für die Einrichthöhe bereitzustellen; gleichzeitig birgt diese Vorgehensweise jedoch das Risiko einer (möglicherweise gravierenden) Ableseungenauigkeit und zusätzlich kann das Wählen nicht-repräsentativer Stellen für die Positionierung des Lineals an der freien Poly-Bruch-Oberfläche trotz des Vorsehens erfahrener Bediener für den Einrichtprozess der Tiegeleinheit nicht völlig ausgeschlossen werden.

Der vorliegenden Erfindung liegt daher die objektive, technische Aufgabe zu Grunde, ein Verfahren zur Ermittlung einer Einrichthöhe an einer Tiegeleinheit bereitzustellen, welches die oben genannten Nachteile nicht oder zumindest in geringerem Ausmaß aufweist und insbesondere auf einfache sowie zuverlässige Weise wenigstens einen für die Einrichthöhe repräsentativen Wert liefert.

### Detaillierte Beschreibung der Erfindung

Gelöst wird die Aufgabe gemäß dem ersten Aspekt der vorliegenden Erfindung durch ein Verfahren zur Ermittlung einer Einrichthöhe an einer, insbesondere wenigstens teilweise mit Bruchstücken, insbesondere Polysiliziumbruchstücken, befüllten Tiegeleinheit gemäß den Merkmalen in Anspruch 1, gemäß dem zweiten Aspekt durch ein Verfahren zur Herstellung eines Einkristallstabs gemäß den Merkmalen nach Anspruch 12, gemäß einem dritten Aspekt durch ein Verfahren zur Herstellung von Scheiben aus Halbleitermaterial umfassend das Verfahren zur Ermittlung der Einrichthöhe an der, insbesondere wenigstens teilweise mit Bruchstücken, insbesondere Polysiliziumbruchstücken, befüllten Tiegeleinheit gemäß den Merkmalen in Anspruch 13, sowie gemäß einem vierten Aspekt durch eine Anlage gemäß den Merkmalen in Anspruch 14. Bevorzugte Ausführungsformen sind Gegenstand der abhängigen Ansprüche.

Der vorliegenden Erfindung liegt hierbei die technische Lehre zu Grunde, dass man auf einfache Weise wenigstens einen zuverlässigen Wert liefern kann, indem man im Zuge des Einrichtprozesses anstatt des manuellen Ableseprozesses der Einrichthöhe wenigstens teilweise automatisierte Messungen an der wenigstens teilweise befüllten Tiegeleinheit vornimmt. Erfindungsgemäß wird dies mit einer Anlage, welche eine entsprechende Messeinheit zur optischen und/oder taktilen Messung aufweist, durchgeführt. Hierdurch wird auf einfache und über viele Einrichtprozesse verschiedener Tiegeleinheiten hinweg sowie unabhängig von der Ablesegenauigkeit des eingesetzten Bedieners eine zuverlässige Lösung für die Ermittlung der Einrichthöhe an einer Tiegeleinheit geschaffen. Weiterhin hat die gegenwärtige Erfindung erkannt, dass ausgehend von diesem Vorsehen einer Anlage mit einer Messeinheit zur optischen und/oder taktilen Messung nicht nur zuverlässige, sondern auf Basis der Ergebnisse der Vermessung mittels der Anlage, insbesondere der Messeinheit, repräsentative Werte für die Einrichthöhe bereitgestellt werden können. Die vier Aspekte der Erfindung verbindet die allgemeine erfinderische Idee, dass auf Basis einer derartigen Verbesserung in der zuverlässigen, korrekten bzw. repräsentativen (d.h. die realen Verhältnisse möglichst genau abbildende) Ermittlung für eine Einrichthöhe unter Berücksichtigung der Notwendigkeit der strikten Einhaltung einer konstruktiv bzw. prozesstechnisch vorgegebenen oberen und unteren maximalen Grenze einer Tiegelbefüllung positiv Einfluss auf ein einheitliches Aufschmelzverhalten des Polysiliziums (bzw. der Polysiliziumbruchstücke) innerhalb des darauffolgenden Tiegelziehprozesses gemäß CZ- Methode genommen werden kann und somit schließlich positiv Einfluss auf die Verteilung der Materialeigenschaften über den gesamten gezogenen Einkristallstab genommen werden kann, wobei sich die Vorteile bis in die daraus weiterverarbeiteten Scheiben aus Halbleitermaterial fortsetzen.

Gemäß dem ersten Aspekt betrifft die Erfindung daher ein Verfahren zur Ermittlung einer Einrichthöhe an einer, insbesondere wenigstens teilweise mit Bruchstücken, insbesondere Polysiliziumbruchstücken, befüllten Tiegeleinheit, mittels einer Anlage, wobei die Anlage eine Messeinheit umfasst, wobei das Verfahren wenigstens folgende Schritte umfasst:
- Erfassen von wenigstens einer geometrischen Abmessung der Tiegeleinheit, insbesondere umfassend das Erfassen einer Oberkantenkontur der Tiegeleinheit, insbesondere mittels der Anlage,
- Optisches und/oder taktiles Vermessen, insbesondere mittels der Anlage, einer Bezugsebene an der Tiegeleinheit,
- Optisches Vermessen, insbesondere mittels der Anlage, wenigstens eines Teils einer, vorzugsweise eines überwiegenden Teils einer, weiter vorzugsweise im Wesentlichen einer gesamten, Bruchtopografie, welche sich in der Tiegeleinheit durch eine, insbesondere vorangegangene, wenigstens teilweise Befüllung mit Bruchstücken, insbesondere mit Polysiliziumbruchstücken, an der freien Oberfläche der Bruchstücke ausbildet,
- Ermitteln, insbesondere mittels der Anlage, wenigstens eines für die Einrichthöhe repräsentativen Wertes wenigstens auf Basis der Ergebnisse der optischen Vermessung des wenigstens einen Teils der, vorzugsweise eines überwiegenden Teils der, weiter vorzugsweise im Wesentlichen der gesamten, Bruchtopografie, und in Bezug auf die Ergebnisse der optischen und/oder taktilen Vermessung der Bezugsebene.

Mit dem erfindungsgemäßen Verfahren können die oben genannten Vorteile der Erfindung in vollem Umfang erzielt werden. Es versteht sich, dass das erfindungsgemäße Verfahren beliebig oft, insbesondere in Abhängigkeit des Ausgangs des Ermittlungsschrittes wiederholt werden kann.

Der Begriff Polybruch im Sinne der Erfindung ist nicht auf bruchstückartige Geometrien von Bruchstücken beschränkt, sondern umfasst auch granulatartig und kugelartig geformte Bruchstücke. Darüber hinaus ist unter Polybruch nicht nur Polysilizium sondern auch monokristallines Silizium zu verstehen.

Eine Befüllspezifikation im Sinne der Erfindung stellt eine vorgegebene Befüllungsanweisung für das schichtweise Befüllen der Tiegeleinheit mit Polybruchstücken dar.

Bei bevorzugten Varianten ist vorgesehen, dass auf Basis wenigstens eines Ergebnisses aus wenigstens einer Messung mittels der Messeinheit wenigstens einer geometrischer Größe, umfassend insbesondere wenigstens eine aus Strecke und Winkel, in Bezug auf eine Achse, insbesondere eine x- und/oder, y- und/oder z-Achse, eines für die Messeinheit definierten Koordinatensystems, ein Vermessen mittels der Anlage erfolgt.
Hierbei ist vorzugsweise vorgesehen, dass der Ursprung des Koordinatensystems in der Messeinheit liegt und/oder der Ursprung des Koordinatensystems in der Bezugsebene liegt. Vorzugsweise umfasst die Ebene wenigsten einen Teil der, weiter vorzugsweise im Wesentlichen die gesamte Oberkantenkontur.
In dem Ermittlungsschritt wird dann vorzugsweise der wenigstens eine für die Einrichthöhe repräsentative Wert in Abhängigkeit des Koordinatensystems, insbesondere des x-/y-/z-Koordinatensystems, ermittelt und ausgegeben.

Zusätzlich zu dieser eben beschriebenen bevorzugten Variante kann vorgesehen sein, dass ein weiteres, zweites Koordinatensystem, vorzugsweise in Form eines X-/Y-Z- Koordinatensystems, durch die Anlage, insbesondere durch die Messeinheit der Anlage, definiert ist.
Vorzugsweise liegt in diesem Fall der Ursprung des zweiten Koordinatensystems, insbesondere des X-/Y-Z- Koordinatensystems, in einer aus der X- und Y-Achse aufgespannten Ebene, wobei die Ebene
(i) wenigstens eine Stelle der Oberkantenkontur schneidet und die Stelle an der Oberkantenkontur insbesondere in der Bezugsebene liegt, und/oder
(ii) mit der Bezugsebene zusammenfällt.

Insbesondere verläuft dann eine Z-Achse des zweiten Koordinatensystems ausgehend von dem Ursprung des zweiten Koordinatensystems, insbesondere des X-/Y-/Z-Koordinatensystems, entlang einer Höhenrichtung in das Tiegelinnere und verläuft einer Mittenachse der Tiegeleinheit folgend. In diesem Fall ist dann in dem Ermittlungsschritt vorzugsweise vorgesehen, dass der wenigstens eine für die Einrichthöhe repräsentative Wert in Abhängigkeit des Koordinatensystems und/oder des zweiten Koordinatensystems, insbesondere in Abhängigkeit des x-/y-/z-Koordinatensystems und/oder in Abhängigkeit des X-/Y-/Z-Koordinatensystems, ermittelt und ausgegeben wird.

Bei einer weiteren bevorzugten Variante ist vorgesehen, dass auf Basis wenigstens eines Ergebnisses aus wenigstens einer Messung mittels der Messeinheit wenigstens einer geometrischer Größe, umfassend insbesondere wenigstens eine aus Strecke und Winkel, in Bezug auf eine x- und/oder, y- und/oder z- Achse eines für die Messeinheit definierten Koordinatensystems, vorzugsweise ein kartesischen Koordinatensystems, ein Vermessen mittels der Anlage erfolgt.

Bei einer weiteren bevorzugten Variante ist vorgesehen, dass die Messeinheit sowohl zur Messung geometrischer Größen, umfassend Messung von Strecken und Winkeln, in Bezug auf eine x- / y- / z- Achse eines für die Messeinheit definierten x-/y-/z-Koordinatensystems und/oder in Bezug auf eine X-/Y-Z- Achse eines durch die Anlage und für die Tiegeleinheit definierten X-/Y-/Z-Koordinatensystems als auch zur Vermessung von Abständen in Bezug auf die x- / y- / z- Achse und/oder die X-/Y-/Z-Achse ausgebildet ist.

Bei besonders vorteilhaften Varianten der Erfindung ist weiterhin vorgesehen, dass dem Beginn des Verfahrens zur Ermittlung der Einrichthöhe, wie oben beschrieben, wenigstens einer der folgenden Schritte, vorzugsweise alle der folgenden Schritte, vorausgehen:
- Platzieren der Tiegeleinheit auf einem Tiegel-Transportwagen,
- Einrichten der Tiegeleinheit gemäß einer vorgebbaren Befüllspezifikation,
- Transport der Tiegeleinheit zu der Anlage und deren Messeinheit oder in der unmittelbaren Nähe der Anlage und deren Messeinheit,
- Arretieren des Tiegel-Transportwagens an der Anlage.

Alternativ zu diesen eben beschriebenen Schritten kann vorgesehen sein, dass dem Beginn des Verfahrens zur Ermittlung der Einrichthöhe wenigstens folgende Schritte vorausgehen:
- Platzieren der Tiegeleinheit auf einem Tiegel-Transportwagen, insbesondere an der Anlage,
- Arretieren des Tiegel-Transportwagens an der Anlage,
- Einrichten der Tiegeleinheit gemäß einer vorgebbaren Befüllspezifikation an der Anlage.

Mit anderen Worten ist in dieser eben genannten Alternative vorgesehen, dass der Transport des Tiegeleinheit-Transportwagens zu der Anlage entfällt, da das Einrichten bereits an der Anlage durchgeführt wird. Diese Variante liefert nicht nur räumliches Einsparpotential für die gesamte Herstellungskette eines herzustellenden Einkristallstabs, sondern auch zeitliches Einsparpotential, da u.a. ein Umrüsten und ein Zwischentransport von der Einrichtungsstelle zu der Ermittlungsstelle, an der Anlage positioniert ist, wegfällt. Dieser Vorteil ist besonders ausgeprägt in dem Fall, wenn im Zuge des Ermittlungsschritts festgestellt wird, dass ein nachträgliches Einrichten von Nöten ist, da beispielsweise an manchen Stellen innerhalb der Tiegeleinheit zu viel oder zu wenig Polybruch geschichtet wurde; mithin wirkt sich die räumliche Nähe der Anlage bzw. räumliche Integration der Anlage zum Einrichtprozess der Tiegeleinheit besonders positiv auf das Verfahren zur Ermittlung der Einrichthöhe aus.

Grundsätzlich kann das Erfassen der spezifischen Tiegeleinheit auf beliebige Art und Weise erfolgen. Bei besonders vorteilhaften Varianten der Erfindung ist vorzugsweise vorgesehen, dass der Schritt des Erfassens wenigstens einer Abmessung der Tiegeleinheit (i) das Erfassen einer Oberkantenkontur der Tiegeleinheit, gebildet vorzugsweise aus einer inneren Umlaufkante der Oberkantenfläche der Tiegeleinheit, umfasst. Zusätzlich oder alternativ kann vorgesehen sein, dass durch ein Erkennen der Tiegeleinheit und deren zugeordneten, bereits bekannten und in der Anlage gespeicherten wenigstens einen Abmessung, insbesondere mittels eines Scanprozesses eines Identifikationscodes, insbesondere Barcodes, an der Tiegeleinheit, erfolgt, oder über eine manuelle Eingabe der wenigstens einen Abmessung an einem Bedienfeld an der Anlage erfolgt, oder durch optisches und/oder taktiles Vermessen wenigstens einer Abmessung der Tiegeleinheit erfolgt. Hierdurch werden in zügiger und zuverlässiger Weise die relevanten Abmessungen der spezifischen Tiegeleinheit erhalten.
Bei bevorzugten Varianten kann die Oberkantenkontur Teil einer Phasenfläche sein, die sich beispielsweise an der inneren Umlaufkante der Oberkantenfläche der Tiegeleinheit ausbildet, wobei die Phasenfläche in Bezug auf eine radiale Richtung der Tiegeleinheit gekrümmt oder im Wesentlichen als Gerade ausgebildet ist. Grundsätzlich kann die Bezugsebene in Form einer Referenzebene an beliebig geeigneter Stelle gewählt werden. Bei besonders vorteilhaften Varianten der Erfindung und für eine einfache Vermessung ist vorzugsweise vorgesehen, dass die Bezugsebene wenigstens einen Bezugspunkt an einer und/oder einen überwiegenden Teil einer, insbesondere im Wesentlichen eine gesamte, Oberkantenkontur der Tiegeleinheit umfasst, wobei insbesondere die Oberkantenkontur aus der inneren oder der äußeren Umlaufkante der Oberkantenfläche der Tiegeleinheit gebildet wird. Zusätzlich oder alternativ ist es vorzugsweise vorgesehen, dass beispielsweise die Bezugsebene und die Messeinheit der Anlage derart relativ zueinander positioniert werden, dass ein x-/y-/z-Koordinatensystem der Messeinheit, welches für das Messen der geometrischen Größen durch die Messeinheit für die Messeinheit definiert ist, innerhalb der Bezugsebene liegt. Hierbei ist es weiterhin denkbar, dass die Messeinheit gewissermaßen an der Oberkantenkontur der Tiegeleinheit aufliegt (d.h. die Messeinheit gewissermaßen "am Anschlag" positioniert ist).
Zusätzlich oder alternativ kann dann das für die Messeinheit definierte x-/y-/z Koordinatensystem mit einem durch die Anlage, insbesondere ebenfalls durch die Messeinheit der Anlage, definierte, weitere Koordinatensystem in Form eines X-/Y-/Z-Koordinatensystems zusammenfallen.

Es ist weiterhin denkbar, dass die Bezugsebene, in Bezug auf ein x-/y-/z-Koordinatensystem der Messeinheit, beliebig geneigt sein kann.

Bei besonders vorteilhaften Varianten der Erfindung ist vorgesehen, dass die Ermittlung der Einrichthöhe ein wenigstens teilweises automatisiertes Vermessen mittels der Anlage umfasst. Bei besonders vorteilhaften Varianten der Erfindung ist vorzugsweise vorgesehen, dass die Ermittlung des wenigstens einen für die Einrichthöhe repräsentativen Wertes durch die Anlage, insbesondere durch eine Ermittlungseinheit der Anlage, vorgenommen wird. Zusätzlich oder alternativ kann eine Ausgabe des wenigstens einen für die Einrichthöhe repräsentativen Wertes durch die Anlage vorgenommen werden und an einer Ausgabeneinheit der Anlage der wenigstens eine für die Einrichthöhe repräsentative Wert dargestellt werden.

Bei besonders vorteilhaften Varianten der Erfindung ist vorzugsweise gemäß einem Schritt (i) vorgesehen, dass
(i) die optische Vermessung wenigstens eines Teils der, vorzugsweise eines überwiegenden Teils der, weiter vorzugsweise im Wesentlichen die gesamte, Bruchtopografie mittels der Anlage, durch
   - eine im Wesentlichen vollflächige Messung der Bruchtopografie bei im Wesentlichen in einer Ruhelage verbleibenden Tiegeleinheit erfolgt, oder
   - durch Messung einer Anzahl von vorgebbaren, insbesondere für die gesamte Bruchtopografie repräsentativen, Messpunkten an der Bruchtopografie bei im Wesentlichen in einer Ruhelage verbleibenden Tiegeleinheit erfolgt, oder
   - durch eine im Wesentlichen vollflächige Messung der Bruchtopografie unter Vollführung einer Rotation, vorzugsweise im Wesentlichen einer 360° Rotation, der Tiegeleinheit um eine durch ein durch die Anlage, insbesondere durch die Messeinheit, für die Tiegeleinheit definierten, insbesondere in einer Höhenrichtung, verlaufenden Z- Achse eines X-/Y-/Z -Koordinatensystems erfolgt.

Vorzugsweise ist weiterhin in dieser bevorzugten Variante gemäß einem weiteren Schritt (ii) vorgesehen, dass
(ii) die Ergebnisse der optischen Vermessung des wenigstens einen Teils der, vorzugsweise eines überwiegenden Teils der, weiter vorzugsweise im Wesentlichen der gesamten, Bruchtopografie, in Bezug auf die Ergebnisse der optischen und/oder taktilen Vermessung der Bezugsebene in dem Ermittlungsschritt folgende Werte liefert:
- ein maximaler Tiefenwert Tₘₐₓ unter Angabe der zugehörigen x, y, z Koordinaten eines durch die Messeinheit definierten x-/y-/z-Koordinatensystems und/oder unter Angabe der zugehörigen X,Y,Z-Koordinaten eines durch die Anlage für die Tiegeleinheit definierten X-/Y-/Z-Koordinatensystems,
- ein minimaler Tiefenwert Tₘᵢₙ unter Angabe der zugehörigen x, y, z Koordinaten eines durch die Messeinheit definierten x-/y-/z-Koordinatensystems und/oder unter Angabe der zugehörigen X,Y,Z-Koordinaten eines durch die Anlage für die Tiegeleinheit definierten X-/Y-/Z-Koordinatensystems,
- eine theoretisch entstandene Fläche der Bruchtopografie unter Angabe der zugehörigen x, y, z Koordinaten eines durch die Messeinheit definierten x-/y-/z-Koordinatensystems und/oder unter Angabe der zugehörigen X,Y,Z-Koordinaten eines durch die Anlage für die Tiegeleinheit definierten X-/Y-/Z-Koordinatensystems,
- und insbesondere eine gemäß einem vorgebbaren Kriterium interpolierte Fläche der Bruchtopografie unter Angabe der zugehörigen x, y, z Koordinaten eines durch die Messeinheit definierten x-/y-/z-Koordinatensystems und/oder unter Angabe der zugehörigen X,Y,Z-Koordinaten eines durch die Anlage für die Tiegeleinheit definierten X-/Y-/Z-Koordinatensystems.

Vorzugsweise ist in dieser bevorzugten Variante weiterhin gemäß einem weiteren Schritt (iii) vorgesehen, dass
(iii) innerhalb des Ermittlungsschritts überprüft wird, ob Tₘᵢₙ und Tₘₐₓ innerhalb vorgebbarer oberen To und unteren Grenzen Tu liegen, und in Abhängigkeit dieses Ergebnisses der Ermittlungsschritt gemäß einem aus folgenden Verfahrensschritten der Ermittlungsschritt weitergeführt wird:
- (iii-a) sollte Tₘᵢₙ geringer als die vorgebbare untere Grenze Tu sein, wird eine Meldung, vorzugsweise in Form einer visuellen Ausgabe über eine Ausgabeeinheit und/oder einer akustischen Ausgabe, vorzugsweise an der Ausgabeeinheit, an der Anlage abgegeben, wonach ein Abtrag an wenigstens jener x-/y-/z-Koordinatenstelle und/oder X-/Y-/Z-Koordinatenstelle, welche der Tₘᵢₙ zugeordnet ist, von wenigstens einem Polybruchstück, insbesondere Polysiliziumbruchstück, erfolgen muss,
- (iii-b) sollten Tₘᵢₙ und Tₘₐₓ innerhalb der vorgebbaren oberen To und unteren Grenzen Tu liegen, wird innerhalb des Ermittlungsschrittes in Abhängigkeit von wenigstens einem dieser Werte aus Schritt (ii), insbesondere unter Berücksichtigung von Tₘᵢₙ und/oder Tₘₐₓ, der wenigstens eine für die Einrichthöhe repräsentative Wert, insbesondere über eine Ermittlungseinheit der Anlage, ermittelt und/oder daraus abgeleitet, und anschließend über die Anlage automatisiert ausgegeben,
- (iii-c) sollte Tₘₐₓ größer als die obere vorgebbare Grenze To sein, wird eine Meldung, vorzugsweise in Form einer visuellen Ausgabe über eine Ausgabeeinheit und/oder einer akustischen Ausgabe, vorzugsweise an der Ausgabeeinheit, an der Anlage abgegeben, wonach insbesondere der Tiegelinhalt mit weiteren Bruchstücken, insbesondere Polysiliziumbruchstücken, weiter befüllt werden muss, sodass die gesamte Polybruchtopografie die untere Grenze Tu überschreitet.

Hierbei sind Tₘᵢₙ und Tₘₐₓ sowie To und Tu jeweils als Abstandsgrößen und dementsprechend als mathematische Beträge (d.h. stets positiver Wert) zu verstehen. Unter Abtrag ist das Entnehmen oder Umschichten von wenigstens einem Polybruchstück, insbesondere Polysiliziumbruchstück, an der freien Polybruch-Oberfläche zu verstehen.

Es versteht sich, dass diese Verfahrensschritte beliebig oft, insbesondere in Abhängigkeit des Ausgangs des Ermittlungsergebnisses betreffend Abgleich zwischen Tₘᵢₙ, Tₘₐₓ mit To und Tu, wiederholt werden kann.

Durch die eben beschriebenen Verfahrensvarianten gemäß den Varianten in den Schritten (i) bis (iii) ist es in einfacher Weise möglich, zuverlässig und vergleichsweise zügig korrekte, die realen Verhältnisse abbildende Werte der Polybruch-Oberfläche zu erhalten und ebenso zu prüfen, ob diese innerhalb vorgegebener Grenzwerte (To, Tu) liegen (mit anderen Worten, ob der Tiegel ausreichend, allerdings auch nicht zu hoch befüllt (und zudem, je nach Wahl von To und Tu, annähernd planar befüllt) ist, um für den weiteren Tiegelziehprozess gemäß CZ-Methode an einer Kristallziehanlage zur Herstellung eines Einkristallstabes ideal eingerichtet zu sein.

Des Weiteren wird es, dank des Verfahrens zur Ermittlung einer Einrichthöhe im Sinne der Erfindung, und insbesondere durch das Vorsehen der eben beschriebenen bevorzugten Verfahrensschritte (i) bis (iii) ermöglicht, bei Durchlaufen der Ermittlungsschritte (und möglichweise nach Durchlaufen einer oder mehrerer Wiederholungen des Einrichtens aufgrund einer Meldung nach Schritt (iii-a) oder Schritt (iii-c) wie oben beschrieben) schließlich wenigstens einen für die Einrichthöhe repräsentativen Wert bereitzustellen, der die realen Befüllungsverhältnisse mit Polysiliziumbruchstücken abbildet, indem konkret der (naturgemäß) wenigstens leicht variierenden Abstand (entlang einer Z- Richtung bzw. in Bezug auf eine Z-Achse (Höhenrichtung) der Tiegeleinheit) der Stellen an der freien Polybruch-Oberfläche in Bezug auf die Tiegeleinheitsoberkantenkontur zunächst ermittelt und sodann auf Basis dieser Ergebnisse so aussagekräftig und realitätsnah wie möglich durch die Anlage, insbesondere durch eine Ermittlungseinheit der Anlage, wenigstens ein für die Einrichthöhe repräsentativer Wert daraus ermittelt und/oder ableitet.
Bei besonders bevorzugten Varianten wird dies durch eine Ermittlung bzw. Ableitung eines (u.a. für den Bediener leicht handhabbaren) Wertepaares zweier in Zusammenhang stehender Werte, verwirklicht, welche dann mittels der Anlage, insbesondere einer Ausgabeeinheit, ausgegeben werden.

Dieses Wertepaar resultiert dann vorzugsweise aus einer Ermittlung bzw. Ableitung, mittels der Anlage, insbesondere mittels einer Ermittlungseinheit der Anlage, unter Berücksichtigung der gesamten, zuvor ermittelten Polybruchtopografie, Tₘᵢₙ und Tₘₐₓ in Form einer IST-Einrichthöhe (im Sinne eines IST-Einrichthöhe-Mittelwerts) unter Angabe der zugehörigen, ermittelten x-/y-/z- Koordinaten plus Standardabweichung.

Hierbei kann die IST-Einrichthöhe wiederum in Form einer Abstandsgröße ausgehend von der Bezugsebene in das Innere der Tiegeleinheit entlang der Z-Richtung bzw. in Bezug auf die Z-Achse der Tiegeleinheit angegeben werden und weiterhin unter Angabe dieser ermittelten bzw. abgeleiteten IST-Einrichthöhe zugeordneter x-/y-Werte angegeben werden.

Es ist bei anderen Varianten der Erfindung auch denkbar, insbesondere wenn die Differenz zwischen ermittelten Tₘᵢₙ und Tₘₐₓ minimal ist, beispielsweise wenn diese Differenz geringer als 1 mm oder beispielsweise geringer als 10 % von Tₘᵢₙ ist, d.h. wenn die Polytopografie vergleichsweise flach ausgebildet ist, ein einziger, für die Einrichthöhe repräsentativer Wert für die Einrichthöhe final ausreichend ist, um die realen Verhältnisse abzubilden und dieser beispielsweise als eine IST-Einrichthöhe bezeichnet bzw. final ausgegeben, vorzugsweise über eine Ausgabeinheit der Anlage, insbesondere automatisiert, ausgegeben wird.

Grundsätzlich kann die Ermittlung wenigstens eines für die Einrichthöhe repräsentativen Wertes auf beliebe Art und Weise erfolgen; beispielsweise kann die Ermittlung wenigstens eines für die Einichthöhe repräsentativen Wertes nach einem der oben beschriebenen Varianten erfolgen. Zusätzlich oder alternativ ist es denkbar, dass der wenigstens eine ermittelte Wert repräsentativ für eine Einrichthöhe ist, welche eine aktuelle IST-Einrichthöhe darstellt, und weiterhin eine vorgebbare SOLL-Einrichthöhe vorgesehen ist, die zwischen einer vorgebbaren oberen Grenze To und einer vorgebbaren unteren Grenzen Tu liegt, wobei die SOLL-Einrichthöhe vorzugsweise dem arithmetischen Mittel aus der vorgebbaren oberen Grenze To und der vorgebbaren unteren Grenzen Tu entspricht, wobei das Verfahren weiterhin folgenden wenigstens einen Verfahrensschritt umfasst: Sollte der wenigstens eine für die IST-Einrichthöhe repräsentative Wert, welcher aus wenigstens einem aus Schritt (ii) gelieferten Wertes ermittelt, insbesondere abgeleitet, wird, ungleich der SOLL-Einrichthöhe sein, insbesondere ungleich der SOLL-Einrichthöhe sein unter Berücksichtigung eines Toleranzbereichs für die SOLL-Einrichthöhe von +/- 25 %, vorzugsweise +/- 10 %, weiter vorzugsweise +/- 5 % und/oder von +/- 5 mm, vorzugsweise +/- 1,5 mm, weiter vorzugsweise +/- 1 mm, wird eine Meldung, vorzugsweise in Form einer visuellen und/oder akkustischen Ausgabe, vorzugsweise an der Ausgabeeinheit, an der Anlage abgegeben.

Bei bevorzugten Varianten kann eine obere Grenze To beispielsweise in dem Bereich von 10 mm bis 15 mm liegen und eine untere Grenze Tu beispielsweise in dem Bereich von 4 mm bis 8 mm liegen. Es versteht sich, dass bei anderen Varianten, die obere und/oder die untere Grenze auch durch andere Werte außerhalb dieses Bereichs vorgegeben werden kann, solange der mathematische Betrag der oberen Grenze To größer ist als der mathematische Betrag der unteren Grenze Tu.

Die oben beschriebenen, bevorzugten Varianten für das Verfahren wurden für Messungen bzw. Vermessungen durch die Anlage auf Basis bzw. in Bezug auf definierte x-/y-/z- sowie X-/Y-/Z- Koordinatensysteme beschrieben, welche insbesondere als kartesische Koordinatensysteme ausgebildet sein können. Es versteht sich jedoch, dass die Erfindung nicht auf die Anwendung derartiger Koordinatensysteme beschränkt ist, sondern beispielsweise eine Messung bzw. Vermessung zusätzlich oder alternativ auch unter Verwendung zylindrischer Koordinatensysteme durchgeführt werden kann. Die Wahl derartiger Koordinatensysteme eignet sich insbesondere für die Anwendung einer Vermessung der Polybruchtopografie unter gleichzeitiger Rotation der Tiegeleinheit um die Höhenachse.

Gemäß dem zweiten Aspekt betrifft die Erfindung ein Verfahren zur Herstellung eines Einkristallstabes, wobei ausgehend von dem Ende des Verfahrens nach einem der oben beschriebenen Varianten zur Ermittlung der Einrichthöhe an der Tiegeleinheit wenigstens folgende Schritte folgen:
- Ausgabe der gelieferten Werte aus dem oben beschriebenen Schritt (ii) sowie Ausgabe des wenigstens einen für die Einrichthöhe repräsentativen Wertes aus Schritt (iii-b) an ein übergeordnetes System an der Anlage oder außerhalb der Anlage,
- Beenden des Messverfahrens,
- Aufsetzen, insbesondere manuelles und/oder maschinelles Aufsetzen, eines Vakuum-Hebeflansches sowie Anlegen eines geforderten Vakuums für den Einbau der Tiegeleinheit in eine Kristallziehanlage,
- Ziehen eines Einkristalls mittels der Kristallziehanlage gemäß der CZ-Methode aus der Tiegeleinheit.

Die eingangs beschriebene allgemeine erfinderische Idee inklusive der erzielten Vorteile wird mittels dieses Verfahrens gemäß einem zweiten Aspekt der Erfindung realisiert.

Gemäß dem dritten Aspekt betrifft die Erfindung ein Verfahren zur Herstellung von Scheiben aus Halbleitermaterial, wobei ausgehend von dem Ende des Verfahrens zur Herstellung eines Einkristallstabs, wie eben beschrieben, wenigstens folgende Schritte folgen:
- Sägen des Einkristalls in dünne Scheiben,
- Chemische und mechanische Weiterbehandlung, insbesondere umfassend wenigstens einen Weiterverarbeitungsschritt aus Kantenverrunden, Läppen, Reinigen, Polieren, Abscheiden einer Oxidschicht, epitaktisches Wachsen einer einkristallinen Schicht, insbesondere Siliziumschicht, oder einer SiGe Schicht oder einer GaN Schicht, an den dünnen Scheiben zu Scheiben aus Halbleitermaterial.

Die eingangs beschriebene allgemeine erfinderische Idee inklusive der erzielten Vorteile wird mittels dieses Verfahrens gemäß einem dritten Aspekt der Erfindung realisiert.

Gemäß dem vierten Aspekt betrifft die Erfindung eine Anlage zur teilautomatisierten Ermittlung einer Einrichthöhe an einer, insbesondere wenigstens teilweise mit Bruchstücken, insbesondere Polysiliziumbruchstücken, befüllten Tiegeleinheit mittels einer Messeinheit der Anlage, wobei
- die Anlage dazu ausgebildet ist, wenigstens eine geometrische Abmessung der Tiegeleinheit, insbesondere umfassend das Erfassen einer Oberkantenkontur der Tiegeleinheit, zu erfassen,
- die Anlage dazu ausgebildet ist, eine optische und/oder taktile Vermessung einer Bezugsebene an der Tiegeleinheit vorzunehmen,
- die Anlage dazu ausgebildet ist, eine optische Vermessung wenigstens eines Teils einer, vorzugsweise eines überwiegenden Teils einer, weiter vorzugsweise im Wesentlichen einer gesamten, Bruchtopografie, welche sich in der Tiegeleinheit durch eine, insbesondere vorangegangene, wenigstens teilweise Befüllung mit Bruchstücken, insbesondere mit Polysiliziumbruchstücken, an der freien Oberfläche der Bruchstücke ausbildet, vorzunehmen,
- die Anlage dazu ausgebildet ist, wenigstens einen für die Einrichthöhe repräsentativen Wert wenigstens auf Basis der Ergebnisse der optischen Vermessung des wenigstens einen Teils der, vorzugsweise eines überwiegenden Teils der, weiter vorzugsweise im Wesentlichen der gesamten, Bruchtopografie, und in Bezug auf die Ergebnisse der optischen und/oder taktilen Vermessung der Bezugsebene, vorzunehmen.

Die eingangs beschriebene allgemeine erfinderische Idee inklusive der erzielten Vorteile wird mittels dieser Anlage gemäß einem vierten Aspekt der Erfindung realisiert.

Die Erfindung wurde vornehmlich ausgehend und anhand des erfindungsgemäßen Verfahrens zur Ermittlung der Einrichthöhe beschrieben. Es versteht sich, dass die hierbei beschriebenen Merkmale gleichermaßen und vollumfänglich für die erfindungsgemäße Anlage gelten, welche zur Ausführung dieser Verfahrensmerkmale ausgebildet ist, sodass zur Vermeidung von Wiederholungen auf die oben beschriebenen technischen Merkmale und deren Vorteile verwiesen wird. Dies gilt ebenso für das erfindungsgemäße Verfahren zur Herstellung eines Einkristrallstabes und für das erfindungsgemäße Verfahren zur Herstellung von Scheiben aus Halbleitermaterial.

### Kurzbeschreibung der Figur

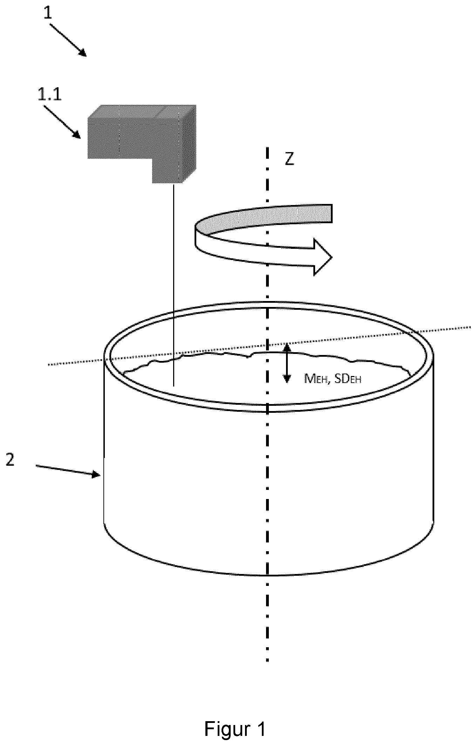

**Figur 1** zeigt einen Zustand während des erfindungsgemäßen Verfahrens zur Ermittlung der Einrichthöhe an einer Tiegeleinheit und die Messeinheit der erfindungsgemäßen Anlage.

### Detaillierte Beschreibung erfindungsgemäßer Ausführungsbeispiele

Im Folgenden wird ein bevorzugtes Ausführungsbeispiel des erfindungsgemäßen Verfahrens zur Ermittlung einer Einrichthöhe an einer Tiegeleinheit (2), welche mit Polybruchstücken in Form von Polysiliumbruchstücken befüllt ist, und eine Anlage (1), welche zur Ermittlung der Einrichthöhe ausgebildet ist, mit Verweis auf Figur 1, näher beschrieben.
Das bevorzugte Ausführungsbeispiel wird im Folgenden vornehmlich ausgehend und anhand des erfindungsgemäßen Verfahrens zur Ermittlung der Einrichthöhe beschrieben. Es versteht sich, dass die hierbei beschriebenen Merkmale gleichermaßen für die Anlage (1) gelten, welche zur Ausführung dieser Verfahrensmerkmale ausgebildet ist.

Bevor das eigentliche Verfahren zur Ermittlung der Einrichthöhe an der Tiegeleinheit (2) an der Anlage (1) startet, durchläuft die Tiegeleinheit (2) folgende Prozessschritte:
- Platzieren der Tiegeleinheit (2) auf einem Tiegel-Transportwagen (nicht gezeigt in Figur 1) an der Anlage (1)
- Arretieren des Tiegel-Transportwagens an der Anlage (1),
- Einrichten der Tiegeleinheit (2) gemäß einer vorgebbaren Befüllspezifikation an der Anlage (1).

Danach startet das Verfahren zur Ermittlung der Einrichthöhe. Nach Inbetriebnahme der Anlage (1) durch den Bediener werden die folgende Schritte mittels der Anlage (1) und ihrer Einheiten durchlaufen:
1) Zunächst werden mittels der Anlage (1) die geometrischen Abmessungen der Tiegeleinheit (2) erfasst. Hierbei werden die für den Einrichtprozess notwendigen und für die Tiegeleinheitsgeometrie repräsentativen Abmessungen erfasst, die für den weiteren Einrichtprozess bzw. für die korrekte Ermittlung bzw. Ableitung einer Einrichthöhe notwendig sind. Hierbei wird die generelle Klasse der Tiegeleinheit (in dem vorliegenden Fall ein 32" Tiegel) erfasst, welche Aufschluss über die allgemeinen Abmessungen der Tiegeleinheitsaußendurchmesser- und innendurchmesser sowie der Tiegelinnenhöhe liefert, welche für die konkrete Tiegeleinheit (2) bereits in der Anlage (1) in einem Speicher hinterlegt sind und durch Scannen eines Identifikationscodes, in dem Fall eines Barcodes, an der Anlage (1) über eine Ausgabeeinheit (nicht in Figur 1 dargestellt) der Anlage (1) abgerufen bzw. ausgegeben werden.
   Des Weiteren wird die Oberkantenkontur der Tiegeleinheit (2) mittels einer Messeinheit (1.1) der Anlage (1) optisch vermessen (bei alternativen Ausführungsformen kann dies zusätzlich oder alternativ auch durch eine taktile Vermessung erfolgen), wobei die Oberkantenkontur in dem vorliegenden Ausführungsbeispiel aus der inneren Umlaufkante der Oberkantenfläche der Tiegeleinheit (2) gebildet wird. Hierbei ist die Messeinheit (1.1) derart ausgebildet, dass sie ein x,y,z - Koordinatensystem in Form eines kartesischen Koordinatensystems definiert und zur Messung geometrischer Größen, umfassend die Messung von Strecken und Winkeln, in Bezug auf die x- / y- / z- Achse bereitstellt, sowie zur Vermessung von Abständen in Bezug auf die x- / y- / z- Achse ausgebildet ist.
2) Danach wird mittels der Messeinheit (1.1) eine optische Vermessung einer Bezugsebene an der Tiegeleinheit vorgenommen. Im vorliegenden Fall umfasst die Bezugsebene im Wesentlichen die gesamte Oberkantenkontur der Tiegeleinheit und dient als Referenzebene für die weiteren Schritte für die Ermittlung bzw. Ableitung wenigstens eines für die Einrichthöhe repräsentativen Werts (im vorliegenden Ausführungsbeispiel in Form eines Wertepaares, s.u.). Ein weiteres Koordinatensystem in Form eines X-/Y-/Z-Koordinatensystems ist durch die Anlage (1), insbesondere durch die Messeinheit (1.1) der Anlage (1), für die Tiegeleinheit (2) definiert, wobei eine aus den X-/Y-Achsen gebildete Ebene mit der Bezugsebene zusammenfällt und die Z-Achse entlang einer Höhenrichtung in das Tiegelinnere und einer Mittenachse (entspricht der Z-Achse) der Tiegeleinheit folgend verläuft. Es versteht sich, dass dies bei anderen bevorzugten Ausführungsbeispielen anders gestaltet werden kann, ohne dass hierdurch vom Wesen der Erfindung abgewichen wird.
3) Anschließend erfolgt eine optische Vermessung mittels der Messeinheit (1.1) (in Bezug auf das x-/y-/z-Koordinatensystem der Messeinheit und in Bezug auf das X-/Y-/Z-Koordinatensystem) im Wesentlichen der gesamten Bruchtopografie, welche sich in der Tiegeleinheit (2) durch die Befüllung mit den Polysiliziumbruchstücken an der freien Oberfläche der Bruchstücke ausgebildet hat. Hierbei erfolgt die optische Vermessung durch eine im Wesentlichen vollflächige Messung der Bruchtopografie unter Vollführung einer im Wesentlichen 360° Rotation der Tiegeleinheit (2) um die durch die Anlage (1), konkret durch die Messeinheit (1.1), für die Tiegeleinheit (2) definierten in Höhenrichtung verlaufenden Z- Achse des X-/Y-/Z -Koordinatensystems erfolgt (Mittenachse).
4) Danach erfolgt der Beginn des eigentlichen Ermittlungsschritts zur Ermittlung des wenigstens einen für die Einrichthöhe repräsentativen Wertes (wie im Folgenden gezeigt wird, im konkreten Ausführungsbeispiel resultiert ein Wertepaar für die Einrichthöhe).
   - Der Ermittlungsschritt in dem vorliegenden Ausführungsbeispiel beginnt damit, dass die Ergebnisse der optischen Vermessung, mittels der Messeinheit (1.1), der im Wesentlichen gesamten Bruchtopografie, in Bezug auf die Ergebnisse der optischen Vermessung der Bezugsebene mittels der Messeinheit (1.1) folgende Werte liefert:
      o ein maximaler Tiefenwert Tₘₐₓ (als eine Abstandsgröße entlang der z-Richtung bzw. entlang der Z-Richtung ausgehend von der Bezugsebene in das Tiegelinnere zu verstehen) unter Angabe der zugehörigen x, y, z Koordinaten eines durch die Messeinheit (1.1) definierten x-/y-/z-Koordinatensystems und/oder unter Angabe der zugehörigen X,Y,Z-Koordinaten eines durch die Anlage (1) für die Tiegeleinheit (2) definierten X-/Y-/Z-Koordinatensystems,
      o ein minimaler Tiefenwert Tₘᵢₙ (als eine Abstandsgröße entlang der z-Richtung bzw. entlang der Z-Richtung) unter Angabe der zugehörigen x, y, z Koordinaten eines durch die Messeinheit (1.1) definierten x-/y-/z-Koordinatensystems und/oder unter Angabe der zugehörigen X,Y,Z-Koordinaten eines durch die Anlage (1) für die Tiegeleinheit (2) definierten X-/Y-/Z-Koordinatensystems,
      o eine theoretisch entstandene Fläche der Bruchtopografie unter Angabe der zugehörigen x, y, z Koordinaten eines durch die Messeinheit (1.1) definierten x-/y-/z-Koordinatensystems und/oder unter Angabe der zugehörigen X,Y,Z-Koordinaten eines durch die Anlage (1) für die Tiegeleinheit (2) definierten X-/Y-/Z-Koordinatensystems,
      o und eine gemäß einem vorgebbaren Kriterium interpolierte Fläche der Bruchtopografie unter Angabe der zugehörigen x, y, z Koordinaten eines durch die Messeinheit (1.1) definierten x-/y-/z-Koordinatensystems und/oder unter Angabe der zugehörigen X,Y,Z-Koordinaten eines durch die Anlage (1) für die Tiegeleinheit (2) definierten X-/Y-/Z-Koordinatensystems.
   - Danach wird innerhalb des Ermittlungsschritts überprüft, ob die Abstände Tₘᵢₙ und Tₘₐₓ innerhalb der vorgegebenen oberen To und unteren Grenzen Tu liegen. Hierbei sind Tₘᵢₙ und Tₘₐₓ sowie To und Tu jeweils als Abstandsgrößen und dementsprechend als mathematische Beträge (d.h. stets positiver Wert) zu verstehen.
   - In Abhängigkeit dieses Ergebnisses ist die Anlage (1) dazu ausgebildet, den Ermittlungsschritt gemäß einem aus folgenden Verfahrensschritten weiterzuführen:
      o sollte Tₘᵢₙ geringer als die vorgebbare untere Grenze Tu sein, wird eine Meldung in Form einer visuellen Ausgabe über eine Ausgabeeinheit (nicht dargestellt) und einer akustischen Ausgabe an der Ausgabeeinheit, an der Anlage (1) abgegeben, wonach ein Abtrag an wenigstens jener x-/y-/z-Koordinatenstelle und X-/Y-/Z-Stelle, welche der Tₘᵢₙ zugeordnet ist, von wenigstens einem Polysiliziumbruchstück erfolgen muss,
      o sollten Tₘᵢₙ und Tₘₐₓ innerhalb der vorgebbarer oberen To und unteren Grenzen Tu liegen, wird innerhalb des Ermittlungsschrittes in Abhängigkeit aller dieser in Schritt 4) gelieferten Werte der wenigstens eine für die Einrichthöhe repräsentative Wert über eine Ermittlungseinheit der Anlage (1) ermittelt bzw. daraus abgeleitet, und anschließend über die Anlage (1) automatisiert ausgegeben,
      o sollte Tₘₐₓ größer als die obere Grenze To sein, wird eine Meldung in Form einer visuellen Ausgabe über eine Ausgabeeinheit und einer akustischen Ausgabe an der Ausgabeeinheit an der Anlage (1) abgegeben, wonach der Tiegelinhalt mit weiteren Polysiliziumbruchstücken weiter befüllt werden muss, sodass die gesamte Polybruchtopografie die untere Grenze Tu überschreitet.
   Im vorliegenden Ausführungsbeispiel wird durch die Anlage (1) festgestellt, dass die Abstände Tₘᵢₙ und Tₘₐₓ zwischen der vorgegebenen unteren Grenze Tᵤ von 5,0 mm und der vorgegebenen oberen Grenze To von 15,0 mm liegen, sodass keine (Warn-)Meldung über die Anlage (1) abgegeben wird und die Ermittlung bzw. Ableitung des wenigstens einen für die Einrichthöhe repräsentativen Wertes auf Basis aller in Schritt 4) gelieferten Werte vorgenommen wird.
   Im vorliegenden Ausführungsbeispiel wird sodann unter Berücksichtigung der gesamten, zuvor ermittelten Polybruchtopografie (d.h. auch unter Berücksichtigung von Tₘᵢₙ und Tₘₐₓ) ein Wertepaar in Form einer IST-Einrichthöhe (im Sinne eines IST-Einrichthöhe-Mittelwerts) unter Angabe zugeordneter x-/y-/z- Koordinaten plus der Standardabweichung, mittels einer Ermittlungseinheit der Anlage, angegeben (in der Form: Einrichthöhenmittelwert M_{EH}/ Standardabweichung SD_{EH}). Hierbei wird die Ist-Einrichthöhe in Form einer Abstandsgröße ausgehend von der Bezugsebene in das Innere der Tiegeleinheit (2) entlang der Z-Richtung bzw. in Bezug auf die Z-Achse angegeben.
5) Im vorliegenden Ausführungsbeispiel ergibt sich ein Wertepaar Einrichthöhenmittelwert M_{EH}/ Standardabweichung SD_{EH} von 10,5 mm / 1,1. Dieses Wertepaar wird über die Anlage (1) an der Ausgabeeinheit (nicht dargestellt in Figur 1) der Anlage (1) automatisiert ausgegeben.

Danach erfolgt das Beenden des Verfahrens zur Ermittlung einer Einrichthöhe. Im vorliegenden Ausführungsbeispiel müssen die Ermittlungsschritte im Zuge des Verfahrens zur Ermittlung wenigstens eines für die Einrichthöhe repräsentativen Wertes nicht wiederholt werden. Es versteht sich jedoch, dass bei anderen Varianten das oben beschriebene Verfahren, insbesondere in Abhängigkeit des Ausgangs des Ermittlungsergebnisses betreffend Abgleich zwischen Tₘᵢₙ, Tₘₐₓ mit To und Tu, beliebig oft wiederholt werden kann.

Danach erfolgt das Aufsetzen eines Vakuum-Hebeflansches auf die Tiegeleinheit (2) sowie das Anlegen des geforderten Vakuums für den Einbau der Tiegeleinheit (2) in die entsprechende Kristallziehanlage zur Herstellung eines Einkristallstabes.

Anschließend startet an der Kristallziehanlage das Tiegel-Ziehverfahren gemäß CZ-Methode zur Herstellung eines Einkristallstabes aus der eben beschriebenen Tiegeleinheit (2).

Schließlich erfolgt in weiteren, folgenden Schritten ausgehend von dem gezogenen Einkristallstab die Herstellung von Scheiben aus Halbleitermaterial, wobei das Verfahren zur Herstellung dieser Scheiben aus Halbleitermaterial folgende Schritte folgen:
- Sägen des Einkristalls in dünne Scheiben,
- Chemische und mechanische Weiterbehandlung, umfassend die Weiterverarbeitungsschritte aus Kantenverrunden, Läppen, Reinigen, Polieren, epitaktisches Wachsen einer einkristallinen Siliziumschicht an den dünnen Scheiben zu Scheiben aus Halbleitermaterial.

Es versteht sich, dass bei anderen Varianten weitere Schritte im Zuge der Herstellung der Scheiben aus Halbleitermaterial ausgehend von dem gezogenen Einkristallstab vorgesehen sein können.

## Patentansprüche

1. Verfahren zur Ermittlung einer Einrichthöhe an einer, insbesondere wenigstens teilweise mit Bruchstücken, insbesondere Polysiliziumbruchstücken, befüllten Tiegeleinheit (2), mittels einer Anlage (1), wobei die Anlage (1) eine Messeinheit (1.1) umfasst, wobei das Verfahren wenigstens folgende Schritte umfasst:
• Erfassen von wenigstens einer geometrischen Abmessung der Tiegeleinheit (2), insbesondere umfassend das Erfassen einer Oberkantenkontur der Tiegeleinheit (2), insbesondere mittels der Anlage (1),
• Optisches und/oder taktiles Vermessen, insbesondere mittels der Anlage (1), einer Bezugsebene an der Tiegeleinheit (2),
• Optisches Vermessen, insbesondere mittels der Anlage (1), wenigstens eines Teils einer, vorzugsweise eines überwiegenden Teils einer, weiter vorzugsweise im Wesentlichen einer gesamten, Bruchtopografie, welche sich in der Tiegeleinheit (2) durch eine, insbesondere vorangegangene, wenigstens teilweise Befüllung mit Bruchstücken, insbesondere mit Polysiliziumbruchstücken, an der freien Oberfläche der Bruchstücke ausbildet,
• Ermitteln insbesondere mittels der Anlage (1), wenigstens eines für die Einrichthöhe repräsentativen Wertes wenigstens auf Basis der Ergebnisse der optischen Vermessung des wenigstens einen Teils der, vorzugsweise eines überwiegenden Teils der, weiter vorzugsweise im Wesentlichen der gesamten, Bruchtopografie, und in Bezug auf die Ergebnisse der optischen und/oder taktilen Vermessung der Bezugsebene.

2. Verfahren nach Anspruch 1, wobei
auf Basis wenigstens eines Ergebnisses aus wenigstens einer Messung mittels der Messeinheit wenigstens einer geometrischer Größe, umfassend insbesondere wenigstens eine aus Strecke und Winkel, in Bezug auf eine x- und/oder, y- und/oder z- Achse eines für die Messeinheit (1.1) definierten Koordinatensystems, ein Vermessen mittels der Anlage (1) erfolgt, wobei
• der Ursprung des Koordinatensystems in der Messeinheit (1.1) liegt und/oder der Ursprung des Koordinatensystems in der Bezugsebene liegt, welche vorzugsweise wenigsten einen Teil der, weiter vorzugsweise im Wesentlichen die gesamte Oberkantenkontur, umfasst, wobei insbesondere der wenigstens eine für die Einrichthöhe repräsentative Wert in Abhängigkeit des x-/y-/z-Koordinatensystems ermittelt und ausgegeben wird.

3. Verfahren nach Anspruch 2, wobei
• ein weiteres Koordinatensystem in Form eines X-/Y-Z- Koordinatensystems durch die Anlage (1), insbesondere durch die Messeinheit (1.1) der Anlage (1), definiert ist,
wobei der Ursprung des X-/Y-Z- Koordinatensystems in einer aus der X- und Y-Achse aufgespannten Ebene liegt, wobei die Ebene
(i) wenigstens eine Stelle der Oberkantenkontur schneidet und die Stelle an der Oberkantenkontur insbesondere in der Bezugsebene liegt, und/oder
(ii) mit der Bezugsebene zusammenfällt, und
• die Z-Achse ausgehend von dem Ursprung des X-/Y-/Z-Koordinatensystems entlang einer Höhenrichtung in das Tiegelinnere und einer Mittenachse der Tiegeleinheit (2) folgend verläuft, wobei der wenigstens eine für die Einrichthöhe repräsentative Wert in Abhängigkeit des x-/y-/z-Koordinatensystems und/oder in Abhängigkeit des X-/Y-/Z-Koordinatensystems ermittelt und ausgegeben wird.

4. Verfahren nach einem der vorherigen Ansprüche, wobei dem Beginn des Verfahrens zur Ermittlung der Einrichthöhe wenigstens folgende Schritte vorausgehen:
• Platzieren der Tiegeleinheit (2) auf einem Tiegel-Transportwagen,
• Einrichten der Tiegeleinheit (2) gemäß einer vorgebbaren Befüllspezifikation,
• Transport der Tiegeleinheit (2) zu der Anlage (1) und deren Messeinheit (1.1) oder in der unmittelbaren Nähe der Anlage (1) und deren Messeinheit (1.1),
• Arretieren des Tiegel-Transportwagens an der Anlage (1.1).

5. Verfahren nach einem der Ansprüche 1 bis 3, wobei dem Beginn des Verfahrens zur Ermittlung der Einrichthöhe wenigstens folgende Schritte vorausgehen:
• Platzieren der Tiegeleinheit (2) auf einem Tiegel-Transportwagen, insbesondere an der Anlage (1),
• Arretieren des Tiegel-Transportwagens an der Anlage (1),
• Einrichten der Tiegeleinheit gemäß einer vorgebbaren Befüllspezifikation an der Anlage (1).

6. Verfahren nach einem der vorherigen Ansprüche, wobei der Schritt des Erfassens wenigstens einer Abmessung der Tiegeleinheit (2)
• das Erfassen einer Oberkantenkontur der Tiegeleinheit (2), gebildet vorzugsweise aus einer inneren Umlaufkante der Oberkantenfläche der Tiegeleinheit (2), umfasst,
und/oder
• durch ein Erkennen der Tiegeleinheit (2) und deren zugeordneten, bereits bekannten und in der Anlage (1) gespeicherten wenigstens einen Abmessung, insbesondere mittels eines Scanprozesses eines Identifikationscodes, insbesondere Barcodes, an der Tiegeleinheit (2), erfolgt, oder über eine manuelle Eingabe der wenigstens einen Abmessung an einem Bedienfeld an der Anlage (1) erfolgt, oder durch optisches und/oder taktiles Vermessen wenigstens einer Abmessung der Tiegeleinheit (2) erfolgt.

7. Verfahren nach einem der vorherigen Ansprüche, wobei die Bezugsebene wenigstens einen Bezugspunkt an einer und/oder einen überwiegenden Teil einer, insbesondere im Wesentlichen eine gesamte, Oberkantenkontur der Tiegeleinheit (2) umfasst, wobei insbesondere die Oberkantenkontur aus der inneren oder der äußeren Umlaufkante der Oberkantenfläche der Tiegeleinheit (2) gebildet wird.

8. Verfahren nach einem der vorherigen Ansprüche, wobei
• die Ermittlung der Einrichthöhe ein wenigstens teilweises automatisiertes Vermessen mittels der Anlage (1) umfasst,
und/oder
• die Ermittlung des wenigstens einen für die Einrichthöhe repräsentativen Wertes durch die Anlage (1), insbesondere durch eine Ermittlungseinheit der Anlage (1), vorgenommen wird,
und/oder
• eine Ausgabe des wenigstens einen für die Einrichthöhe repräsentativen Wertes durch die Anlage (1) vorgenommen wird und vorzugsweise an einer Ausgabeneinheit der Anlage (1) der wenigstens eine für die Einrichthöhe repräsentative Wert dargestellt wird.

9. Verfahren nach einem der vorherigen Ansprüche, wobei
(i) die optische Vermessung wenigstens eines Teils der, vorzugsweise eines überwiegenden Teils der, weiter vorzugsweise im Wesentlichen die gesamte, Bruchtopografie mittels der Anlage (1), durch
• eine im Wesentlichen vollflächige Messung der Bruchtopografie bei im Wesentlichen in einer Ruhelage verbleibenden Tiegeleinheit (2) erfolgt,
oder
• durch Messung einer Anzahl von vorgebbaren, insbesondere für die gesamte Bruchtopografie repräsentativen, Messpunkten an der Bruchtopografie bei im Wesentlichen in einer Ruhelage verbleibenden Tiegeleinheit (2) erfolgt,
oder
• durch eine im Wesentlichen vollflächige Messung der Bruchtopografie unter Vollführung einer Rotation, vorzugsweise im Wesentlichen einer 360° Rotation, der Tiegeleinheit (2) um eine durch ein durch die Anlage (1), insbesondere durch die Messeinheit (1.1), für die Tiegeleinheit (2) definierten, insbesondere in einer Höhenrichtung, verlaufenden Z-Achse eines X-/Y-/Z - Koordinatensystems erfolgt.
und wobei
(ii) die Ergebnisse der optischen Vermessung des wenigstens einen Teils der, vorzugsweise eines überwiegenden Teils der, weiter vorzugsweise im Wesentlichen der gesamten, Bruchtopografie, in Bezug auf die Ergebnisse der optischen und/oder taktilen Vermessung der Bezugsebene in dem Ermittlungsschritt folgende Werte liefert:
• ein maximaler Tiefenwert Tₘₐₓ unter Angabe der zugehörigen x, y, z Koordinaten eines durch die Messeinheit (1.1) definierten x/-y/-/z-Koordinatensystems und/oder unter Angabe der zugehörigen X,Y,Z-Koordinaten eines durch die Anlage (1) für die Tiegeleinheit (2) definierten X/-Y/-/Z-Koordinatensystems,
• ein minimaler Tiefenwert Tₘᵢₙ unter Angabe der zugehörigen x, y, z Koordinaten eines durch die Messeinheit (1.1) definierten x/-y/-/z-Koordinatensystems und/oder unter Angabe der zugehörigen X,Y,Z-Koordinaten eines durch die Anlage (1) für die Tiegeleinheit (2) definierten X/-Y/-/Z-Koordinatensystems,
• und insbesondere eine gemäß einem vorgebbaren Kriterium interpolierte Fläche der Bruchtopografie unter Angabe der zugehörigen x, y, z Koordinaten eines durch die Messeinheit (1.1) definierten x/-y/-/z-Koordinatensystems und/oder unter Angabe der zugehörigen X,Y,Z-Koordinaten eines durch die Anlage (1) für die Tiegeleinheit (2) definierten X/-Y/-/Z-Koordinatensystems,
und wobei
(iii) innerhalb des Ermittlungsschritts überprüft wird, ob Tₘᵢₙ und Tₘₐₓ innerhalb vorgebbarer oberen To und unteren Grenzen Tu liegen, und in Abhängigkeit dieses Ergebnisses der Ermittlungsschritt gemäß einem aus folgenden Verfahrensschritten der Ermittlungsschritt weitergeführt wird:
• (iii-a) sollte Tₘᵢₙ geringer als die vorgebbare untere Grenze Tu sein, wird eine Meldung, vorzugsweise in Form einer visuellen Ausgabe über eine Ausgabeeinheit und/oder einer akustischen Ausgabe, vorzugsweise an der Ausgabeeinheit, an der Anlage (1) abgegeben, wonach ein Abtrag an wenigstens jener x-/y-/z-Koordinatenstelle und/oder X-/Y-/Z-Koordinatenstelle, welche der Tₘᵢₙ zugeordnet ist, von wenigstens einem Polybruchstück, insbesondere Polysiliziumbruchstück, erfolgen muss,
• (iii-b) sollten Tₘᵢₙ und Tₘₐₓ innerhalb der vorgebbarer oberen To und unteren Grenzen Tu liegen, wird innerhalb des Ermittlungsschrittes in Abhängigkeit von wenigstens einem dieser Werte aus Schritt (ii), insbesondere unter Berücksichtigung von Tₘᵢₙ und/oder Tₘₐₓ, der wenigstens eine für die Einrichthöhe repräsentative Wert über die Anlage (1), insbesondere über eine Ermittlungseinheit der Anlage (1), ermittelt und/oder daraus abgeleitet, und anschließend über die Anlage (1) automatisiert ausgegeben,
• (iii-c) sollte Tₘₐₓ größer als die obere Grenze To sein, wird eine Meldung, vorzugsweise in Form einer visuellen Ausgabe über eine Ausgabeeinheit und/oder einer akustischen Ausgabe, vorzugsweise an der Ausgabeeinheit, an der Anlage (1) abgegeben, wonach insbesondere der Tiegelinhalt mit weiteren Bruchstücken, insbesondere Polysiliziumbruchstücken, weiter befüllt werden muss, sodass die gesamte Polybruchtopografie die untere Grenze Tu überschreitet.

10. Verfahren nach Anspruch 9, wobei mittels einer Ermittlungseinheit der Anlage (1), unter Berücksichtigung der gelieferten Werte aus Schritt (iii-b) ein Wertepaar (M_{EH}/ SD_{EH})) in Form einer IST-Einrichthöhe in Form eines IST-Einrichthöhe-Mittelwerts, insbesondere umfassend die Angabe zugehöriger x-/y- Koordinaten, plus zugehöriger Standardabweichung ermittelt und/oder abgeleitet wird.

11. Verfahren nach Anspruch 9 oder 10, wobei
der wenigstens eine ermittelte Wert repräsentativ für eine Einrichthöhe ist, welche eine aktuelle IST-Einrichthöhe darstellt, und weiterhin eine vorgebbare SOLL-Einrichthöhe vorgesehen ist, die zwischen der vorgebbaren oberen Grenze To und der vorgebbaren unteren Grenzen Tu liegt, wobei die SOLL-Einrichthöhe vorzugsweise dem arithmetischen Mittel aus der vorgebbaren oberen Grenze To und der vorgebbaren unteren Grenzen Tu entspricht, wobei das Verfahren weiterhin folgenden wenigstens einen Schritt umfasst:
• sollte der wenigstens eine für die IST-Einrichthöhe repräsentative Wert, welcher aus wenigstens einem aus Schritt (ii) gelieferten Wertes ermittelt, insbesondere abgeleitet, wird, ungleich der SOLL-Einrichthöhe sein, insbesondere ungleich der SOLL-Einrichthöhe sein unter Berücksichtigung eines Toleranzbereichs für die SOLL-Einrichthöhe von +/- 25 %, vorzugsweise +/- 10 %, weiter vorzugsweise +/- 5 % und/oder von +/- 5 mm, vorzugsweise +/- 1,5 mm, weiter vorzugsweise +/- 1 mm, wird eine Meldung, vorzugsweise in Form einer visuellen und/oder akkustischen Ausgabe, vorzugsweise an der Ausgabeeinheit, an der Anlage (1) abgegeben.

12. Verfahren zur Herstellung eines Einkristallstabes, wobei ausgehend von dem Ende des Verfahrens nach einem der Ansprüche 9 bis 11 zur Ermittlung der Einrichthöhe an der Tiegeleinheit (2) wenigstens folgende Schritte folgen:
• Ausgabe der gelieferten Werte aus Schritt (ii) sowie des wenigstens einen für die Einrichthöhe repräsentativen Wertes aus Schritt (iii) an ein übergeordnetes System an der Anlage (1) oder außerhalb der Anlage (1),
• Beenden des Messverfahrens,
• Aufsetzen eines Vakuum-Hebeflansches sowie Anlegen eines geforderten Vakuums für den Einbau der Tiegeleinheit (2) in eine Kristallziehanlage,
• Ziehen eines Einkristalls mittels der Kristallziehanlage gemäß der CZ-Methode aus der Tiegeleinheit (2).

13. Verfahren zur Herstellung von Scheiben aus Halbleitermaterial, wobei ausgehend von dem Ende des Verfahrens nach Anspruch 12 wenigstens folgende Schritte folgen:
• Sägen des Einkristalls in dünne Scheiben,
• Chemische und mechanische Weiterbehandlung, insbesondere umfassend wenigstens einen Weiterverarbeitungsschritt aus Kantenverrunden, Läppen, Reinigen, Polieren, Abscheiden einer Oxidschicht, epitaktisches Wachsen einer einkristallinen Schicht, insbesondere Siliziumschicht, oder einer SiGe Schicht oder einer GaN Schicht, an den dünnen Scheiben zu Scheiben aus Halbleitermaterial.

14. Anlage zur wenigstens teilweise automatisierten Ermittlung einer Einrichthöhe an einer, insbesondere wenigstens teilweise mit Bruchstücken, insbesondere Polysiliziumbruchstücken, befüllten Tiegeleinheit (2) mittels einer Messeinheit (1.1) der Anlage (1), wobei
• die Anlage (1) dazu ausgebildet ist, wenigstens eine geometrische Abmessung der Tiegeleinheit (2), insbesondere umfassend das Erfassen einer Oberkantenkontur der Tiegeleinheit (2), zu erfassen,
• die Anlage (1) dazu ausgebildet ist, eine optische und/oder taktile Vermessung einer Bezugsebene an der Tiegeleinheit (2) vorzunehmen,
• die Anlage (1) dazu ausgebildet ist, eine optische Vermessung wenigstens eines Teils einer, vorzugsweise eines überwiegenden Teils einer, weiter vorzugsweise im Wesentlichen einer gesamten, Bruchtopografie, welche sich in der Tiegeleinheit (2) durch eine, insbesondere vorangegangene, wenigstens teilweise Befüllung mit Bruchstücken, insbesondere mit Polysiliziumbruchstücken, an der freien Oberfläche der Bruchstücke ausbildet, vorzunehmen,
• die Anlage (1) dazu ausgebildet ist, wenigstens einen für die Einrichthöhe repräsentativen Wert wenigstens auf Basis der Ergebnisse der optischen Vermessung des wenigstens einen Teils der, vorzugsweise eines überwiegenden Teils der, weiter vorzugsweise im Wesentlichen der gesamten, Bruchtopografie, und in Bezug auf die Ergebnisse der optischen und/oder taktilen Vermessung der Bezugsebene, vorzunehmen.

15. Anlage zur wenigstens teilweise automatiserten Ermittlung einer Einrichthöhe nach Anspruch 14, die zur Ausführung des Verfahrens zur Ermittlung der Einrichthöhe nach einem der Ansprüche 1 bis 11 ausgebildet ist.
